# EUROPEAN PATENT APPLICATION

(11) **EP 1 710 915 A1**
(43) Date of publication of application: **11.10.2006**
(21) Application number: 05709238.9
(22) Date of filing: 07.01.2005
(51) Int. Cl.: H03K 21/40

(54) **IF COUNTING METHOD**

(30) Priority: 26.01.2004 JP 2004017243
(71) Applicant: KABUSHIKI KAISHA TOYOTA JIDOSHOKKI, Kariya-shi, Aichi 448-8671 (JP); Niigata Seimitsu Co., Ltd., Jouetsu-shi, Niigata 943-0834 (JP)
(72) Inventor: GOTO, S., Kabushiki Kaisha Toyota Jidoshokki, Kariya-shi, Aichi 4488671 (JP); MIYAGI, Hiroshi, Niigata Seimitsu Co., Ltd., Joetsu-shi, Niigata 9430834 (JP)
(74) Representative: TBK-Patent
(86) International application number: PCT/JP2005/000151
(87) International publication number: WO 2005/071839

(57) **Abstract**

In order to provide an IF counting method for realizing an IF counter with a smaller circuit configuration, an IF counter comprises a countdown IF counting unit 1 for counting frequency-divided IF signals, an IF count time period determination unit 2 for determining a count time period, an IF count upper limit presetting unit 3 for providing the countdown IF counting unit 1 with an initial value, a lower-order m-bit comparison unit 5 for comparing the lower-order m bits of the value counted by the countdown IF counting unit 1 with information preset in the IF count upper/lower limit difference presetting unit 3 and a determination unit 6 for determining whether the count value is within a prescribed range, according to the higher-order (n+1-m) bits of the value counted by the countdown IF counting unit 1 and the comparison result of the lower-order m-bit comparison unit.

## Description

### Field of the Invention

The present invention relates to an IF counting method of an IF counter used in radio receivers.

### Background of the Invention

A conventional IF counter used to count an intermediate frequency (IF) in radio receivers, for example, comprises an n-bit IF counting unit 15, an IF count time period determination unit 16 for determining the IF count time period of the IF counting unit 15, an IF count upper limit presetting unit 17 for setting an IF count upper limit value composed of n bits, an IF count lower limit presetting unit 18 for setting an IF count lower limit value composed of n bits, an upper limit comparison unit 19 composed of n-bits for comparing a value counted by the IF counting unit 15 with a preset value of the IF count upper limit presetting unit 17, a lower limit comparison unit 20 for comparing a value counted by the IF counting unit 15 with an preset value of the IF count lower limit presetting unit 18 and a determination unit 21 for determining whether the count value of the IF counting unit 15 is within a prescribed range based on the comparison result of the upper limit comparison unit 19 and the comparison result of the lower limit comparison unit 20.

When receiving an IF signal passed through a limiter circuit or the like, the IF counting unit 15 counts IF signals inputted during a prescribed time period determined by the IF count time period determination unit 16.

The value counted by the IF counting unit 15 is inputted to the upper limit comparison unit 19 and lower limit comparison unit 20. The upper limit comparison unit 19 compares an inputted count value with the IF count upper limit value preset in the IF count upper limit presetting unit 17. For example, if the count value > the IF count upper limit value, the upper limit comparison unit 19 outputs "0" as the comparison result. If the count value ≤ the IF count upper limit value, the upper limit comparison unit 19 outputs 1 as the comparison result.

Similarly, the lower limit comparison unit 20 compares an inputted count value with the IF count lower limit value preset in the IF count lower limit presetting unit 18. For example, if the count value < the IF count lower limit value, the lower limit comparison unit 20 outputs "0" as the comparison result. If the count value ≥ the IF count lower limit value, the upper limit comparison unit 20 outputs 1 as the comparison result.

The comparison results of the upper limit comparison unit 19 and lower limit comparison unit 20 are inputted to the determination unit 21 and it is determined whether the count value is within the IF count upper and lower limits, respectively.

For example, by calculating the logical AND of the comparison result of the upper limit comparison unit 19 and that of the lower limit comparison unit 20 in the determination unit 21, it is detected that the count value is between the IF count upper and lower limits if the output of the determination unit 21 is 1.

Patent reference 1 discloses an FM radio receiver capable of automatically comparing the name of an FM/RDS adjacent broadcast station with that of a firstly automatically detected broadcast station and automatically modifying it based on the broadcast station name. Patent reference 1 discloses a means for comparing frequencies when automatically scanning a desired frequency.

Patent reference 2 discloses an IF counting method for measuring the amount of errors in the number of IF pulses during a specific time period by counting the 1/0 ratio of data demodulated by a demodulation circuit in parallel to the counting of the number of IF pulses. In this method, an accurate IF frequency value can be obtained without being affected by a count error due to modulation by using a frequency counting circuit for measuring an IF frequency by correcting an IF count by a correction circuit using the measured amount of errors.

Patent reference 1: Japanese Patent Application No.H10-341138

Patent reference 2: Japanese Patent Application No.H11-234353

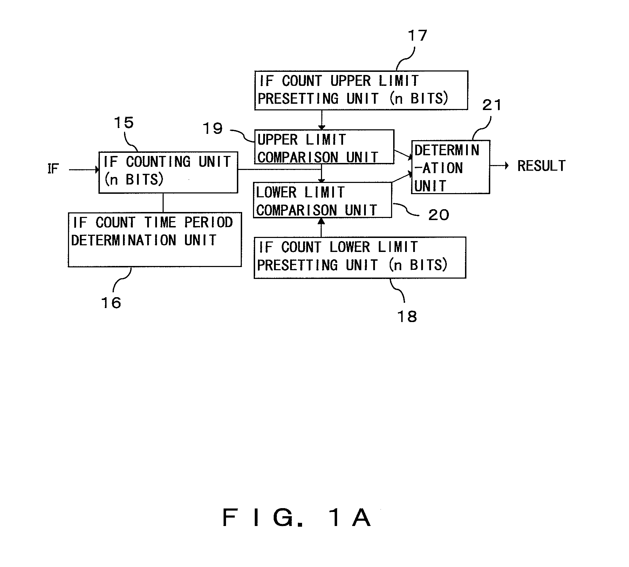

As described above, for example, in the conventional circuit shown in Fig. 1A, the scale of its circuit configuration becomes large. Especially, in order to realize a radio receiver with one chip, the circuit must be made slimmer than ever.

### Summary of the Invention

The present invention is made to solve the problem, and it is an object of the present invention to provide an IF counting method for realizing an IF counting with a circuit configuration smaller than ever.

The invention set forth in claim 1 is an IF counting method for counting IF signals during a prescribed time period. The IF counting method comprises an upper limit presetting step of providing the desired upper limit of a count value as an initial value at the time of count commencement, an IF count time period determination step of determining a time period during which the IF signals are counted, a countdown IF counting step of counting down the initial value set in the upper limit presetting unit for the time period determined by the IF count time period determination step according to the count value of the IF signals, an IF count upper/lower limit difference presetting step of providing information about the difference between the desired upper and lower limits of the count value, a comparison step of comparing the information about the difference between the IF count upper/lower limit values provided by the IF count upper/lower limit difference presetting step with first information based on the count information of the countdown IF counting step and a determination step of determining whether the count value is between the desired upper and lower limits, according to second information based on the count information of the countdown IF counting step and the result of the comparison step.

According to the invention set forth in claim 1, by decrementing the value set in the upper limit presetting step according to the count value of the IF signals in the countdown IF counting step, if the count value of the IF signals is larger than the upper limit value, after the value is counted down to 0, further decrement makes the highest-order bit become 1. Thus, it can be determined that the count value of the IF signals is larger than the desired upper limit. If the value set in the IF count upper/lower limit difference presetting step is larger the value based on the first information and also all bits constituting the second information are "0", it can be determined that the count value of the IF signals is between the desired upper and lower limits. In this case, if all bits constituting the second information are not "0", it can be determined whether the count value of the IF signals is within a prescribed range by setting so in the upper limit presetting step and the IF counting upper/lower limit difference presetting step in advance, since it can be determined that the count value of the IF signals is smaller than the desired lower limit. In this case, since the number of bits constituting the desired lower limit value set in the upper/lower limit difference presetting step and the number of bits constituting information compared in the comparison step can be reduced, the scale of the circuit configuration can be reduced.

The invention set forth in claim 2 is the IF counting method according to claim 1, wherein with integers m and n in which n > m and each of which is more than 1, the first information is the lower-order m bits of count information composed of (n +1) bits in the countdown IF counting step and the second information is the higher-order (n+1-m) bits of the count information.

According to the invention set forth in claim 2, it brings the same effect as in claim 1, that is, if the highest-order bit of the higher-order (n+1-m) bits information of the count value of the IF signals, counted by the countdown IF counting step is 1, it can be determined that the count value of the IF signals is larger than the desired upper limit. If all the higher-order (n+1-m) bits of the higher-order (n+1-m) bits information of the count value of the IF signals, counted by the countdown IF counting step are "0", and also the lower-order m-bit value of the value of the IF signals, counted by the countdown IF counting step is smaller than the value set by the IF count upper/lower limit difference presetting step, it can be determined that the count value of the IF signals is between the desired upper and lower limits. If all the higher-order (n+1-m) bits of the higher-order (n+1-m) bits information of the count value of the IF signals counted by the countdown IF counting step are not "0", it can be determined that the count value of the IF signals is smaller than the desired lower limit.

The invention set forth in claim 3 is the IF counting method wherein the frequency of each of the IF signals is divided by selectively using one of frequency division ratios, 1/2, 1/4, 1/8, 1/16 and 1/32.

According to the invention set forth in claim 3, in addition to the effect of claim 1, IF signals with higher frequencies can be counted by modifying a frequency division ratio even when the frequencies of the IF signals are high.

The invention set forth in claim 4 is an IF counting method for counting IF signals during a prescribed time period. The IF counting method comprises an upper limit presetting step of providing the desired upper limit of a count value as an initial value at the time of count commencement, an IF count time period determination step of determining a time period during which the IF signals are counted, a countdown IF counting step of counting down the initial value set in the upper limit presetting step for the time period determined by the IF count time period determination step according to the count value of the IF signals and a determination step of determining whether the count value is between the desired upper and lower limits, according to the first and second information based on the count information of the countdown IF counting step.

According to the invention set forth in claim 4, by decrementing the value set in the upper limit presetting step by the value of the IF signals counted by the countdown IF counting step, if the count value of the IF signals is larger than the upper limit value, after the value is counted down to 0, further decrement makes the highest-order bit constituting the first information become 1. Thus, it can be determined, in the determination step, that the count value of the IF signals is larger than the desired upper limit. If all bits constituting the second information are "0", it can be determined, in the determination step, that the count value of the IF signals is between the desired upper and lower limits. Further, if all bits constituting the second information are not "0" it can be determined that the count value of the IF signals is smaller than the desired lower limit. Thus, it can be determined whether the count value of the IF signals is within a prescribed range by setting the upper limit set in the upper limit presetting step in advance, and the scale of the circuit configuration can be reduced since the presetting step of the lower limit value is not needed.

The invention set forth in claim 5 is an IF counter for counting IF signals during a prescribed time period. The IF counter comprises an upper limit presetting unit for providing the desired upper limit of a count value as an initial value at the time of count commencement, an IF count time period determination unit for determining a time period during which the IF signals are counted, a countdown IF counting unit for counting down the initial value set in the upper limit presetting unit for the time period determined by the IF count time period determination unit according to the count value of the IF signals, an IF count upper/lower limit difference presetting unit for providing information about the difference between the desired upper and lower limits of the count value, a comparison unit for comparing the information about the difference between the IF count upper/lower limit values provided by the IF count upper/lower limit difference presetting unit with first information based on the count information of the countdown IF counting unit and a determination unit for determining whether the count value is between the desired upper and lower limits, according to second information based on the count information of the countdown IF counting unit and the result of the comparison unit.

According to the invention set forth in claim 5, by decrementing the value set in the upper limit presetting unit according to the count value of the IF signals by the countdown IF counting unit, if the count value of the IF signals is larger than the upper limit value, after the value is counted down to 0, further decrement makes the highest-order bit become 1. Thus, the determination unit can determine that the count value of the IF signals is larger than the desired upper limit. If the comparison result in the comparison unit shows that the value set in the IF count upper/lower limit difference presetting unit is larger than the value based on the first information and also all bits constituting the second information are "0", the determination unit can determine that the count value of the IF signals is between the desired upper and lower limits. Further, if all bits constituting the second information are not "0", the determination unit determines that the count value of the IF signals is smaller than the desired lower limit. Thus, the above described IF counter can provide the same effect as in claim 1, that is, it can determine that the count value of the IF signals is within the prescribed range by setting the upper limit value in the upper limit presetting unit and the IF counting upper/lower limit difference presetting unit in advance and, since the number of bits constituting the upper/lower limit difference presetting unit and the number of bits constituting the comparison unit can be reduced, the scale of the circuit configuration can be reduced.

The invention set forth in claim 6 is an IF counter for counting IF signals for a prescribed time period. The IF counter comprises an upper limit presetting unit for providing the desired upper limit of a count value as an initial value at the time of count commencement, an IF count time period determination unit for determining a time period during which the IF signals are counted, a countdown IF counting unit for counting down the initial value set in the upper limit presetting unit for the time period determined by the IF count time period determination unit according to the count value of the IF signals and a determination unit for determining whether the count value is between the desired upper and lower limits, according to the first and second information based on the count information of the countdown IF counting unit.

According to the invention set forth in claim 6, by decrementing the value set in the upper limit presetting unit according to the count value of the IF signals by the countdown IF counting unit, if the count value of the IF signals is larger than the upper limit value, after the value is counted down to 0, further decrement makes the highest-order bit constituting the first information become 1. Thus, the determination unit can determine that the count value of the IF signals is larger than the desired upper limit. If all bits constituting the second information are "0", the determination unit can determine that the count value of the IF signals is between the desired upper and lower limits. Further, if all bits constituting the second information are not "0", the determination unit determines that the count value of the IF signals is smaller than the desired lower limit. Thus, the IF counter can provide the same effect as in claim 4, that is, it can determine whether the count value of the IF signals is within a prescribed range by setting the upper limit set in the upper limit presetting unit in advance and, since the presetting step of the lower limit value is not needed, the scale of the circuit configuration can be reduced.

### Brief Description of the Drawings

Fig. 1A shows the functional configuration of the conventional IF counter.
Fig. 1B shows the functional configuration of the first preferred embodiment of the present invention.
Fig. 2 is the circuit diagram of the major part in the first preferred embodiment of the present invention.
Fig. 3 shows the waveforms of the major part, outputted by the circuit shown in Fig. 2.
Fig. 4 shows the functional configuration of the second preferred embodiment of the present invention.

### Detailed Description of the Preferred Embodiments

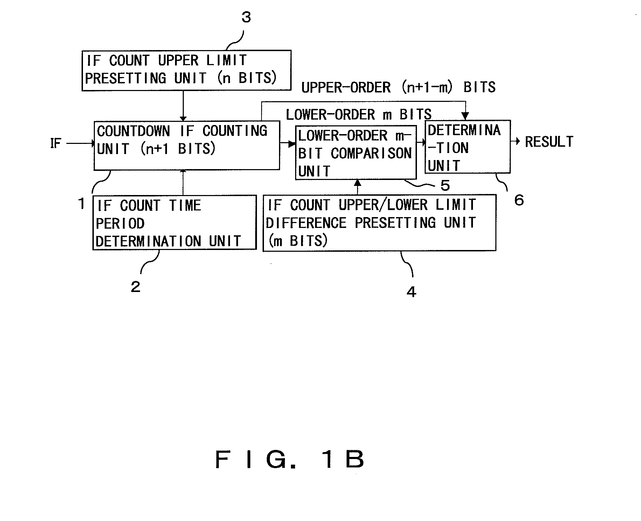

The preferred embodiments of the present invention are described below with reference to Figs. 1B-4.

Fig. 1B shows the functional configuration of the first preferred embodiment of the present invention.

An IF counter according to this preferred embodiment comprises a countdown IF counting unit 1 for counting frequency-divided IF signals, an IF count time period determination unit 2 for determining a count time period during which the IF signals are counted, an IF count upper limit presetting unit 3 for providing the countdown IF counting unit 1 with an initial value at the time of count commencement, a lower-order m-bit comparison unit 5 for comparing the lower-order m bits of the value counted by the countdown IF counting unit 1 with information preset in the IF count upper/lower limit difference presetting unit and a determination unit 6 for determining whether the count value is within a prescribed range, according to the higher-order (n+1-m) bits of the value counted by the countdown IF counting unit 1 and the comparison result of the lower-order m-bit comparison unit. An IF counter according to this preferred embodiment is formed on a semiconductor circuit substrate by a CMOS process capable of manufacturing p-channel/n-channel MOS transistors.

The countdown IF counting unit 1 has a function to count data composed of (n+1) bits. The IF counting unit counts IF signals by decrementing the initial value, for example, which is data preset in the IF count upper limit presetting unit 3 and composed of n bits, for a prescribed time period determined by the IF count time period determination unit 2.

The IF count time period determination unit 2 determines a time period during which the countdown IF counting unit 1 counts IF signals. Specifically, the IF count time period determination unit 2 monitors a clock signal inputted to the countdown IF counting unit 1 and transmits a resetting signal to the countdown IF counting unit 1 after the specific determined time elapses.

In the IF count upper limit presetting unit 3, the upper limit of an n-bit IF count value is preset, and the IF count upper limit presetting unit 3 provides the countdown IF counting unit 1 with an initial value at the time of count commencement.

In the IF count upper/lower limit difference presetting unit 4, the difference between the upper and lower limits of an m-bit IF count value is preset, which is used to compare with the lower-order m-bit of the (n+1) bit value counted by the countdown IF counting unit 1.

To the lower-order m-bit comparison unit 5, the lower-order m bits of the value of the IF signals counted by the countdown IF counting unit 1 and the difference between the upper and lower limits of the IF count value preset in the IF count upper/lower limit presetting unit 4 are inputted and compared. The lower-order m-bit comparison unit 5 outputs the comparison result to the determination unit 6.

The determination unit 6 determines whether the count value of the IF signals is between the upper limit preset in the IF count upper limit presetting unit 3 and the lower limit based on the value preset in the IF count upper limit presetting unit 3 and IF count upper/lower limit difference presetting unit 4, based on the upper-order (n+1-m) bits of the value of the IF signals, counted by the countdown IF counting unit 1 and the comparison result of the lower-order m- bit comparison unit 5 and outputs its result. Specifically, if the highest-order bit of the upper (n+1-m) bits of the value of the IF signals, counted by the countdown IF counting unit 1 is 1, it is determined that the count value of the IF signals is larger than the desired upper limit. If all the higher-order (n+1-m) bits in the higher-order (n+1-m) bits' information of the count value of the IF signals counted by the countdown IF counting unit 1 are "0", and also the lower-order m bits of the value of the IF signals counted by the countdown IF counting unit 1 is smaller than the value preset in the IF count upper/lower limit difference presetting unit 4, it is determined that the count value of the IF signals is between the desired upper and lower limits. Further, if all the higher-order (n+1-m) bits in the higher-order (n+1-m) bits' information of the value of the IF signals counted by the countdown IF counting unit 1 are not "0", it is determined that the count value of the IF signals is smaller than the desired lower limit. By configuring thus, for example, in the preferred embodiment of the present invention, the circuit scale can be reduced since each component can be composed of a small number of bits by using the lower-order m-bit comparison unit 5 composed of m bits in which n > m and the IF count upper/lower limit difference presetting unit 4, although the conventional circuit configuration requires the comparison unit composed of n-bits (upper limit comparison unit 19 and lower limit comparison unit 20 shown in Fig. 1A) and the IF count lower limit presetting unit 20.

Thus, it can be determined whether the IF signal frequency is between the desired upper and lower limits, without using the IF count lower limit presetting unit 18 composed of n-bits and lower limit comparison unit 20, shown in Fig. 1A, thereby reducing the scale of the circuit configuration more than ever.

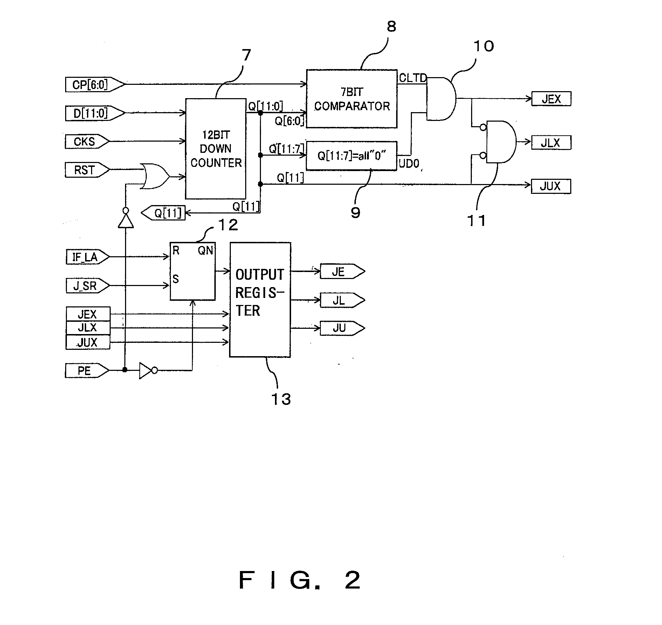

Fig. 2 is the circuit diagram of the major part in the first preferred embodiment of the present invention.

The IF counter used in this preferred embodiment comprises at least a 12-bit countdown counter 7 for frequency-divided IF signals, a 7-bit comparator 8 for comparing the lower-order seven bits of the value, counted by the 12-bit countdown counter 7 with a value which is preset in the IF count upper/lower limit difference presetting unit, composed of a dip switch, register and the like, which are not shown in Fig. 2, and is obtained via a signal line CP, an AND circuit 9 for determining whether all the higher-order five bits of the value counted by the 12-bit countdown counter 7 are "0", an AND circuit 10 for calculating a logical AND between the comparison result of the seven-bit comparator 8 and that of the AND circuit 9, an AND circuit 11 for calculating a logical AND between the inversion bits of the output of the AND circuit 10 and the inversion bits of the highest-order bit (12 bits) of a value counted by the 12-bit countdown counter, an output register 13 for outputting a determination result about whether the count value of the IF signals is between upper/lower limits which are determined based on the IF count upper limit presetting unit composed of a dip switch, register and the like, which are not shown in Fig. 2 and the IF count upper/lower limit difference presetting unit, and an RS flip-flop 12 for controlling a signal outputted from the output register 13.

The 12-bit countdown counter 7 corresponds to the countdown IF counting unit 1 shown in Fig. 1B. To the 12-bit countdown counter 7, the signal D of data preset in the IF count upper limit presetting unit composed of 11-bits and is constituted of a dip switch, register and the like, which are not shown in Fig. 2, an IF signal CKS obtained by further frequency-dividing the IF signals to be counted by a frequency divider, which is not shown in Fig. 2, via a limiter circuit, which is not shown In Fig. 2 and an RST, being a resetting signal, are inputted.

When the resetting signal RST is inputted, the data preset in the IF count upper limit presetting unit composed of a dip switch, register and the like, which are not shown in Fig. 2, is set in the 12-bit countdown counter 7 via the signal D. The 12-bit countdown counter 7 counts down the count value using the set IF count upper limit as an initial value, according to the IF signal CKS.

In this case, 1/2, 1/4, 1/8, 1/16, 1/36 or the like can be selectively used for the frequency division ratio of the frequency divider, and its time base is set to approximately between 4mS and 32mS as requested.

The 7-bit comparator 8 corresponds to the lower-order m-bit comparator shown in the Fig. 1B. To the 7-bit comparator 8, the signal CP of the data preset in the 7-bit IF count upper/lower difference presetting unit composed of a dip switch, register and the like, which are not shown in Fig. 2, and the lower-order 7-bit data Q[6:0] of the 12-bit countdown counter 7 are inputted, and if the signal Q[6:0] < the signal CP, "1" is outputted as an output signal CLTD.

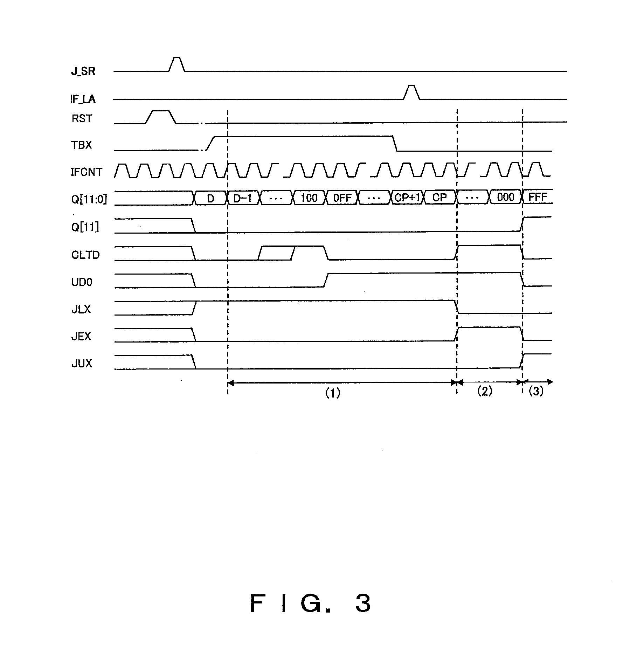

The AND circuits 9-11 correspond to the determination unit 6 shown in Fig. 1B. If the higher-order 5 bits data Q[11:7] of the 12-bit countdown counter 7 is inputted and all the bits are "0", the AND circuit 9 outputs "1" as an output signal UD0. If the signal Q[11] is "1", "1" is outputted as an output signal JUX when the output signal CLTD from the 7-bit comparator 8, the output signal UD0 from the AND circuit 9 and the highest-order bit data Q[11] of the 12-bit countdown counter 7 are inputted to the AND circuits 10 and 11 (section (3) shown in Fig. 3). If the signal CLTD is "1" and also the signal UD0 is "1", "1" is outputted as an output signal JEX (section (2) shown in Fig. 3). If the signal JUX is "0" and also the signal JEX is "0", "1" is outputted as an output signal JLX (section (1) shown in Fig. 3).

An input signal J_SR, which is an input signal to the RS flip-flop 12, is outputted from the IF count time period determination circuit which is not shown in Fig. 2 and indicates the beginning of the count time period in synchronization with the resetting signal RST. An input signal IF_LA is also outputted from the IF count time period determination circuit which is not shown in Fig. 2 and indicates the end of the count time in synchronization with a time base signal TBX.

If "1" is inputted to the signal IF_LA and also "0" is inputted to the signal J_SR (whereby, the signal TBX indicating an IF count time period determined by the IF count time period determination circuit which is not shown in Fig. 2 becomes off and the IF_LA indicating the end of a time base period becomes on), "1" is outputted to an output signal QN. If "1" is inputted from an input signal QN, the output register 13 outputs the signals JEX, JLX and JUX as output signals JE, JL and LU, respectively.

Thus, if the IF signal CKS is larger than the upper limit value preset in the IF count upper limit presetting unit composed of a dip switch, a register and the like, which are not shown in Fig. 2, an output signal (JE, JL, LU) becomes (0, 0, 1) . If the IF signal CKS is between the upper limit and the lower limit based on the IF count upper/lower limit difference presetting unit and IF counter upper limit presetting unit, the output signal (JE, JL, JU) becomes (1, 0, 0). If the IF signal CKS is smaller than the lower limit, the output signal (JE, JL, JU) becomes (0, 1, 0).

Fig. 3 shows the waveforms of the major part, outputted by the circuit shown in Fig. 2.

When the input signal J_SR to the RS flip-flop 12 becomes ON in synchronization with the signal RST, the output register 13 is reset. Furthermore, the signal TBX indicating an IF count time period (time base period) is made ON by the IF count time period determination circuit, and the 12-bit countdown counter 7 starts its countdown using the value which is preset in the IF count upper limit presetting unit composed of a dip switch, a register and the like and inputted from the signal D, as an initial value.

Fig. 3 shows the case where the signal TBX becomes OFF in the section (1) shown in Fig. 3. Specifically, when the signal TBX becomes OFF, the input signal IF_LA to the RS flip-flop 12 becomes ON and the states of the signals JEX, JLX and JUL in section (1) are outputted as signals JE, JL and JU, respectively, via the output register 13 (in this case, the output signal (JE, JL, JU) becomes (0, 1, 0)).

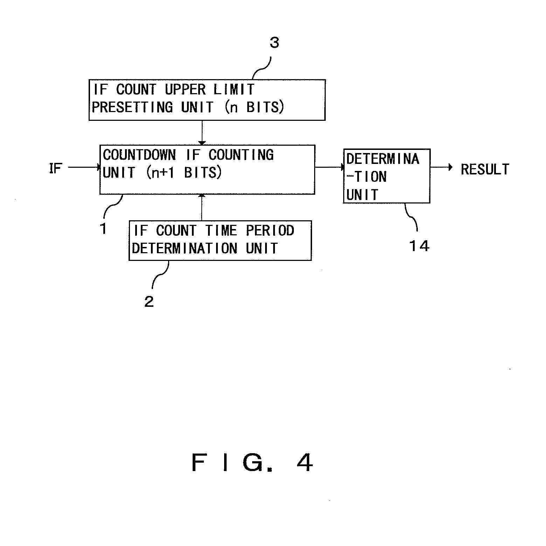

Fig. 4 shows the functional configuration of the second preferred embodiment of the present invention.

The IF counter according to this preferred embodiment comprises an (n+1)-bit countdown IF counting unit 1, an IF count time period determination unit 2 for determining the IF count time period of the countdown IF counting unit 1, an IF count upper limit presetting unit 3 for setting an n-bit IF count upper limit and a determination unit 14 for determining whether a value counted by the countdown IF counting unit 1 is within a prescribed range.

The countdown IF counting unit 1 has a function to count (n+1)-bit data. IF signals are counted, for example, by decrementing, one by one, the count value for a prescribed time period determined by the IF count time period determination unit 2, using n-bit data preset in the IF count upper limit presetting unit 3 as an initial value.

The IF count time determination unit 2 determines a time period during which the countdown IF counting unit 1 counts IF signals. Specifically, the IF count time period determination unit 2 monitors a clock signal inputted to the countdown IF counting unit 1 and transmits a resetting signal to the countdown IF counting unit 1 after the predetermined time elapses.

The determination unit 14 determines whether the count value is between the prescribed upper and lower limits when the value counted by the countdown IF counting unit 1 is inputted. In this case, the prescribed upper limit value is preset in the IF count upper limit presetting unit 3, and the lower limit value is m-bit data, where n > m.

If the highest-order bit ((n+1) bits) of the value counted by the countdown IF counting unit 1 is "1", it is determined that IF count value > IF count upper limit. In this case, if all the higher-order (n+1-m) bits counted by the countdown IF counting unit 1 are "0", it is determined that IF count lower limit ≤ IF count value ≤IF count upper limit. Furthermore, if all the higher-order (n+1-m) bits counted by the countdown IF counting unit 1 are not "0", it is determined that IF count value < IF lower count limit.

By such a configuration, the circuit scale can be reduced further.

This preferred embodiment can be realized by using a circuit obtained by eliminating the 7-bit comparator 8 and AND circuit 10 from the circuit diagram shown in Fig. 2 (therefore, the signal CP and signal Q[6:0] are not used).That is, the output UD0 from the AND circuit 9 becomes an output signal JEX and an input signal to the AND circuit 11.

Other circuit configurations are the same as those shown in Fig. 2.That is, the 12-bit countdown counter 7 corresponds to the countdown IF counting unit 1 shown in Fig. 4. To the 12-bit countdown counter 7, the signal D of the data preset in the IF count upper limit presetting unit composed of 11-bits and is constituted of a dip switch, a register and the like, which are not shown in Fig. 2, IF signal CKS obtained by frequency-dividing IF signals to be counted by the frequency divider, which is not shown in Fig. 2, via a limiter circuit, which is not shown in Fig. 2, and an RST, being a resetting signal, are inputted.

If the resetting signal RST is inputted, the data preset in the IF count upper limit presetting unit composed of a dip switch, a register and the like, which are not shown, is set in the 12-bit countdown counter 7 via the signal D. The 12-bit countdown counter 7 counts down the count value using the set IF count upper limit as an initial value according to the IF signal CKS.

In this case, 1/2, 1/4, 1/8, 1/16, 1/36 or the like can be selectively used as the frequency division ratio of the frequency divider, and its time base is set to approximately between 4mS and 32mS as requested.

The AND circuits 9 and 11 correspond to the determination unit 14 shown in Fig. 4. If all the bits are "0" when the higher-order 5-bit data Q[11:7] of the 12-bit countdown counter 7 is inputted, the AND circuit 9 outputs "1" as an output signal UD0. If the signal Q[11] is "1" when the output signal from the AND circuit UD0 and the highest-order bit data Q[11] of the 12-bit countdown counter 7 are inputted, "1" is outputted as an output signal JUX (section (3) shown in Fig. 3). If the signal UD0 is "1", "1" is outputted as an output signal JEX (section (2) shown in Fig. 3). If the signal JUX is "0" and also the signal JEX is "0", "1" is outputted as an output signal JLX (section (1) shown in Fig. 3).

An input signal J_SR, which is an input signal to the RS flip-flop 12, is outputted from the IF count time period determination circuit which is not shown in Fig. 2 and indicates the beginning of the count time period in synchronization with the resetting signal RST. An input signal IF_LA is also outputted from the IF count time period determination circuit which is not shown in Fig. 2 and indicates the end of the count time period in synchronization with a time base signal TBX.

If "0" is inputted to the signal IF_LA and also "1" is inputted to the signal J_SR (whereby, the signal TBX indicating an IF count time period determined by the IF count time period determination circuit which is not shown in Fig. 2 becomes OFF and the IF_LA indicating the end of a time base period becomes ON), "1" is outputted to an output signal QN. If "1" is inputted from an input signal QN, the output register 13 outputs the signals JEX, JLX and JUX as output signals JE, JL and LU, respectively.

Thus, if the IF signal CKS is larger than the upper limit value preset in the IF count upper limit presetting unit composed of a dip switch, a register and the like, which are not shown in Fig. 2, an output signal (JE, JL, LU) becomes (0, 0, 1) . If the IF signal CKS is between the upper limit and the lower limit based on the IF count upper presetting unit, the output signal (JE, JL, JU) becomes (1, 0, 0). If the IF signal CKS is smaller than the lower limit, the output signal (JE, JL, JU) becomes (0, 1, 0).

By such a configuration, the circuit scale can be more reduced than that of the IF counter described in the first preferred embodiment.

As described above, according to any aspect of the present invention, an IF counting method can be realized by a circuit configuration smaller than ever.

## Claims

1. An IF counting method of an IF counter for counting IF signals for a prescribed time period, comprising:
upper limit presetting step for providing a desired upper limit of a count value as an initial value at the time of count commencement;
IF count time period determination step for determining a time period during which the IF signals are counted;
countdown IF counting step for counting down the initial value preset of the upper limit presetting step for the time period determined in the IF count time period determination step, by a count value of the IF signals;
IF count upper/lower limit difference presetting step for providing information about a difference between desired upper and lower limits of the count value;
comparison step for comparing the information about the difference between the IF count upper/lower limit values provided in the IF count upper/lower limit difference presetting step with first information based on count information of the countdown IF counting step; and
determination step for determining whether the count value is between the desired upper and lower limits, according to second information based on the count information of the countdown IF counting step and a result of the comparison step.

2. The IF counting method according to claim 1, wherein
the said first information is the lower-order m bits of count information composed of (n +1) bits in the said countdown IF counting step and the said second information is the higher-order (n+1-m) bits of the count information, where each of integers m and n is more than 1 and n > m.

3. The IF counting method according to claim 1, wherein
the frequency of each of the IF signals is divided by selectively using one of frequency division ratios out of 1/2, 1/4, 1/8, 1/16 and 1/32.

4. An IF counting method for an IF counter for counting IF signals for a prescribed time period, comprising:
upper limit presetting step for providing a desired upper limit of a count value as an initial value at the time of count commencement;
IF count time period determination step for determining a time period during which IF signals are counted;
countdown IF counting step for counting down the initial value set in the upper limit presetting step for the time period determined by the IF count time period determination step according to the count value of the IF signals; and
determination step for determining whether the count value is between the desired upper and lower limits, according to the first and second information based on the count information of the countdown IF counting step.

5. An IF counter for counting IF signals for a prescribed time period, comprising:
an upper limit presetting unit for providing a desired upper limit of a count value as an initial value at the time of count commencement;
an IF count time period determination unit for determining a time period during which the IF signals are counted;
a countdown IF counting unit for counting down an initial value set in the upper limit presetting unit for the time period determined by the IF count time period determination unit according to the count value of the IF signals;
an IF count upper/lower limit difference presetting unit for providing information about a difference between the desired upper and lower limits of the count value;
a comparison unit for comparing the information about the difference between the preset value in the IF count upper/lower limit difference presetting unit with first information based on the count information of the countdown IF counting unit; and
a determination unit for determining whether the count value is between the desired upper and lower limits, according to second information based on the count information of the countdown IF counting unit and a result of the comparison unit.

6. An IF counter for counting IF signals for a prescribed time period, comprising:
an upper limit presetting unit for providing a desired upper limit of a count value as an initial value at the time of count commencement;
an IF count time period determination unit for determining a time period during which the IF signals are counted;
a countdown IF counting unit for counting down the initial value set in the upper limit presetting unit for the time period determined by the IF count time period determination unit according to the count value of the IF signals; and
a determination unit for determining whether the count value is between the desired upper and lower limits, according to the first and second information based on the count information of the countdown IF counting unit.
